# EUROPEAN PATENT APPLICATION

(11) **EP 2 551 922 A2**
(43) Date of publication of application: **30.01.2013**
(21) Application number: 12178183.5
(22) Date of filing: 27.07.2012
(51) Int. Cl.: H01L 33/00, H01L 33/20, H01L 33/46

(54) **LED structure and method for manufacturing the same**

(30) Priority: 27.07.2011 TW 100126624
(71) Applicant: Lextar Electronics Corp., 30075 Hsinchu (TW)
(72) Inventor: Chen, Cheng-Hung, 330 Taoyuan County (TW); Hsia, Der-Lin, 238 New Taipei City (TW); Hou, Chia-Hung, 806 Kaohsiung City (TW)
(74) Representative: von Kreisler Selting Werner

(57) **Abstract**

The present invention discloses a LED structure including a reflection layer (122) and a method for manufacturing the LED structure. The reflection layer (122) is formed as a reflection block inside each of the groove (102) that might gather light which is emitted toward the back side of the LED structure, and that makes the light conversion efficiency and illumination increase correspondingly.

## Description

### BACKGROUND OF THE INVENTION

### 1. Field of the Invention

The present invention relates to a LED structure and a method for manufacturing the same; in particular, to a LED structure which has a reflection layer and a method for manufacturing the same.

### 2. Description of Related Art

Light Emitting Diode (LED) has advantages of small size, long lifespan, low power consumption, luminescence and mercury free so that has become the main research project in illuminating field. The power development of LED is gradually advanced from low-power to high-power and has various applications of LED illuminating products. For example, LEDs replace fluorescent tubes and light bulbs, and are wildly used in household appliances, computer screens, cell phones, illuminating equipments, medical equipments, and traffic lights.

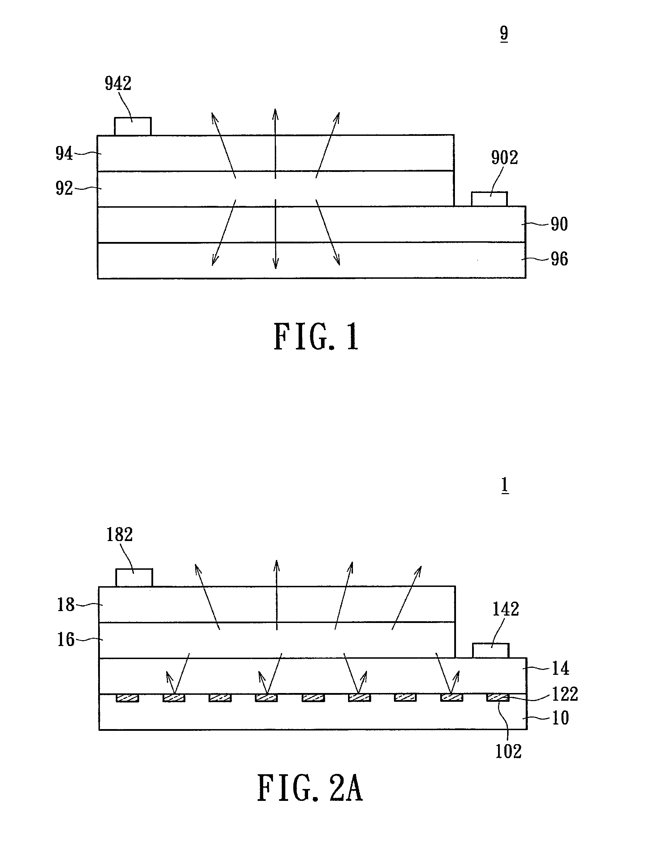

As shown in FIG. 1, FIG.1 shows a sectional view of a traditional LED structure. The traditional LED structure 9 has an n-type semiconductor layer 90, a light emitting layer 92, and a p-type semiconductor layer 94 which are sequentially disposed on a substrate 96. The n-type semiconductor layer 90 is coupled with an electrode 902, and the p-type semiconductor layer 94 is coupled with another electrode 942, too. The light emitting layer 92 can be driven by a voltage drop between said two electrodes to generate light when the voltage drop reaches a preset value. In general, users may select one surface of the LED structure 9 as an emergence surface, and the emergence surface is aligned toward an object configured to receive the light. In this case, the p-type semiconductor layer 94 is the emergence surface (front side) of the LED structure 9, and the substrate 96 is the back side of the LED structure 9.

In practice, the light emitting layer 92, however, may not only emit the light toward the emergence surface, but also emit the light toward the opposite surface (the substrate 96). Thus, the light generated by the light emitting layer 92 may not be emitted toward one direction so that the light can not be used efficiently. Besides, the temperature of the LED structure 9 might greatly increase when the light is absorbed by the layers of the LED structure 9, and that makes the light conversion efficiency and illumination decrease correspondingly. Therefore, in order to enhance the illumination of the LED structure 9, it is important that the light generated by the light emitting layer 92 shall be gathered and emitted toward the emergence surface.

### SUMMARY OF THE INVENTION

The object of the present invention is to a LED structure having a reflection layer for reflecting the light which is emitted toward the back side of the LED structure. Therefore, the LED structure of the present invention can gather the light generated by the light emitting layer and direct the light to emit toward the emergence surface, that the illumination of the LED structure of the present invention can be greatly enhanced.

In order to achieve the aforementioned objects, the present invention discloses a LED structure. The LED structure includes a substrate, a reflection layer, a first conducting layer, a light emitting layer, and a second conducting layer. The substrate has a plurality of grooves, and the reflection layer is disposed inside the plurality of grooves. The reflection layer is formed as a reflection block inside each of the grooves. The first conducting layer is disposed on the substrate, that is, the reflection layer is disposed between the first conducting layer and the substrate. The light emitting layer is disposed on the first conducting layer, and the second conducting layer is disposed on the light emitting layer. The light emitting layer generates light when a current pass through the first conducting layer, the light emitting layer, and the second conducting layer.

According to an embodiment of the present invention, a plurality of air gaps can be formed between the reflection layer and the first conducting layer, each air gap is sandwiched between the first conducting layer and one of the reflection blocks within the corresponding groove. Besides, each air gap can have a depth-width ratio, the depth-width ratio is modulated according to the ratio of V semiconductor material and III semiconductor material while manufacturing the first conducting layer during an epitaxy process, and the grooves can be formed on an upper surface of the substrate, and the upper surface and the reflection layer disposed inside the grooves are in coplanar.

The object of the present invention is to a method for manufacturing a LED structure having a reflection layer for reflecting the light which is emitted toward the back side of the LED structure. Therefore, the LED structure of the present invention can gather the light generated by the light emitting layer and direct the light to emit toward the emergence surface, that the illumination of the LED structure of the present invention can be greatly enhanced.

In order to achieve the aforementioned objects, the present invention discloses a method for manufacturing a LED structure as follows. First, a patterned photoresist layer can be disposed on a substrate. Then, a photolithography process can be performed. The photolithography process is applied for etching a plurality of portions of the substrate which are not covered by the patterned photoresist layer, and a plurality of grooves can be formed on the substrate. In addition, the locations of the grooves are corresponded to the portions. Then, a reflection layer can be formed on the patterned photoresist layer and the grooves, and the reflection layer can be formed as one of a plurality of reflection blocks inside each groove. Then, the patterned photoresist layer is removed. Then, a first conducting layer can be formed on the substrate and covers the grooves. Then, a light emitting layer can be formed on the first conducting layer. Then, a second conducting layer can be formed on the light emitting layer. To be noted, the light emitting layer generates light when a current pass through the first conducting layer, the light emitting layer, and the second conducting layer.

To sum up, the reflection layer of the present invention is disposed inside the grooves of the substrate, and that makes the upper surface of the substrate and the reflection layer (reflection blocks) be in substantially coplanar. Accordingly, the layers (e.g. conducting layers) can be easily disposed on the substrate because the upper surface of the substrate is not scraggly. Furthermore, the LED structure of the present invention can gather the light generated by the light emitting layer and direct the light to emit toward the emergence surface, that the illumination of the LED structure of the present invention can be greatly enhanced.

In order to further the understanding regarding the present invention, the following embodiments are provided along with illustrations to facilitate the disclosure of the present invention.

### BRIEF DESCRIPTION OF THE DRAWINGS

FIG.1 shows a sectional view of a traditional LED structure;

FIG. 2A shows a sectional view of a LED structure according to an embodiment of the present invention;

FIG. 2B shows a sectional view of the groove according to an embodiment of the present invention;

FIG. 2C shows a sectional view of the groove according to another embodiment of the present invention;

FIG. 2D shows a schematic diagram of the air gap according to an embodiment of the present invention;

FIG. 2E shows an enlarged schematic diagram of area E in FIG. 2D;

FIG. 3 shows a flow chart of manufacturing the LED structure according to an embodiment of the present invention; and

FIGS. 4A-4E show sectional views of the LED structure during a manufacturing process according to an embodiment of the present invention.

### DETAILED DESCRIPTION OF THE PREFERRED EMBODIMENTS

The aforementioned illustrations and following detailed descriptions are exemplary for the purpose of further explaining the scope of the present invention. Other objectives and advantages related to the present invention will be illustrated in the subsequent descriptions and appended drawings.

[An embodiment for LED structure]

Referring to FIG. 2A, FIG. 2A shows a sectional view of a LED structure according to an embodiment of the present invention. As shown in FIG. 2A, the present invention discloses a LED structure 1. The LED structure 1 includes a substrate 10, a reflection layer (not shown in FIG. 2A), a first conducting layer 14, a light emitting layer 16, and a second conducting layer 18. The reflection layer, the first conducting layer 14, the light emitting layer 16, and the second conducting layer 18 are sequentially disposed on the substrate 10, so that the first conducting layer 14 is sandwiched between the substrate 10 and the light emitting layer 16, and the light emitting layer 16 is sandwiched between the first conducting layer 14 and the second conducting layer 18. In FIG. 2A, the upper surface of the second conducting layer 18 can be considered as an emergence surface of the LED structure 1. To be noted, in order to explicitly show features of each layer, the layers in those figures may not be drawn in the precise scale.

The material of the substrate 10 could be silicon, gallium nitride, aluminium nitride, sapphire, spinel, silicon carbide, gallium arsenide, aluminium oxide, lithium gallium oxide, lithium aluminium oxide, magnesium aluminum oxide, or other appropriate materials. In practice, the material of the substrate 10 of this embodiment takes sapphire for example, a plurality of grooves 102 can be disposed on a surface of the substrate 10. The present invention does not limit the shape of the grooves 102 and the arrangement of the grooves 102. For example, each groove 102 could be, but not limited to, bar-shape in top view and triangle-shape in sectional view, bar-shape in top view and rectangular-shape in sectional view, or bar-shape in top view and semicircular-shape in sectional view. For those skilled in the art can design the shape groove 102 as needed.

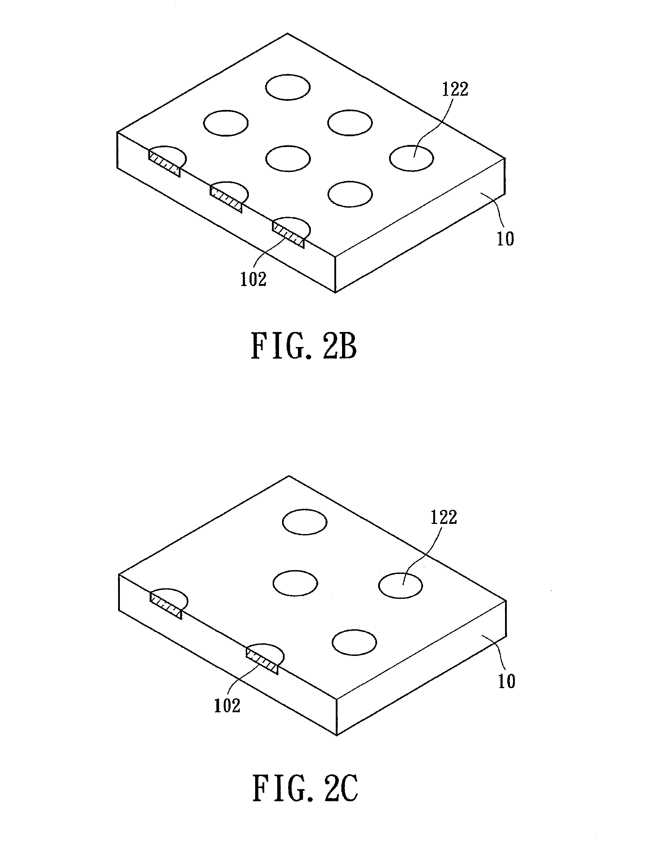

Take the groove 102 with the semicircular-shape in sectional view for example, referring to FIGS. 2B and 2C, FIG. 2B shows a sectional view of the groove according to an embodiment of the present invention, and FIG. 2C shows a sectional view of the groove according to another embodiment of the present invention. As shown in figures, the grooves 102 can be regularly disposed on the surface of the substrate 10 in arrayed fashion (as FIG. 2B), and the grooves 102 can also be randomly disposed on the surface of the substrate 10 (as FIG. 2C). For example, in order to enhance the efficiency of reflection, the grooves 102 as a whole can be, but not limited to, arranged in triangle-shape, hexagon-shape, and rectangular-shape in top view. For those skilled in the art can design the arrangement of the grooves 102 as needed.

Referring to FIG. 2A, the reflection layer is disposed inside the grooves 102 and formed as a plurality of reflection blocks 122, and each reflection block 122 can be disposed inside one of the grooves 102. In practice, the material of the reflection layer (and the reflection blocks 122) can be, but not limited to, silica, titania, tantalum oxide, silicon nitride, or other appropriate materials. Besides, the grooves 102 are formed on an upper surface of the substrate 10, and the thickness of each reflection blocks 122 and the depth of each grooves 102 shall be substantially the same, so that the reflection blocks 122 disposed inside the grooves 102 and the upper surface could be in substantially coplanar. In other words, the reflection blocks 122 of the present invention are lodged in the substrate 10, thus the upper surface of the substrate 10 could be smooth, and it is easier to form other layers on the substrate 10 by an epitaxy process.

Of course, the present invention does not limit the upper surface of the substrate 10 shall be exactly flatness, the reflection blocks 122 can still slightly higher/lower than the upper surface of the substrate 10. As long as the reflection blocks 122 do not interfere with the epitaxy process, those skilled in the art could design the thickness of each reflection blocks 122 and the depth of each grooves 102 as needed.

To be noted, the reflection efficiency is proportion to the total area of the substrate 10 covered by the reflection blocks 122. Larger the total area of the reflection blocks 122, more light generated by the light emitting layer can be gathered and directed toward the emergence surface, that the illumination of the LED structure of the present invention can be greatly enhanced. However, the present invention suggest that the total area of the substrate 10 covered by the reflection blocks 122 shall be under carefully controlled, if the total area of the substrate 10 covered by the reflection blocks 122 is too large, it might have serious endurance problems, since other layers might not be able to be disposed on the substrate 10 stably. In addition, if the endurance problems can be eliminate, for those skilled in the art could adjust the ratio of the total area of the reflection blocks 122 and the total area of the substrate 10as needed.

Referring to FIG. 2A, the first conducting layer 14 is disposed on the substrate 10, and the reflection layer (and the reflection blocks 122) can be sandwiched between the substrate 10 and the first conducting layer 14. The light emitting layer 16 and the second conducting layer 18 are sequentially disposed on the first conducting layer 14. Specifically, the first conducting layer 14 could be a n-type semiconductor layer, the second conducting layer 18 could be a p-type semiconductor layer, and the first conducting layer 14 and the second conducting layer 18 could be coupled with the corresponding electrode (142 and 182) respectively. The light emitting layer 16 generates light when a current pass through the first conducting layer 14, the light emitting layer 16, and the second conducting layer 18.

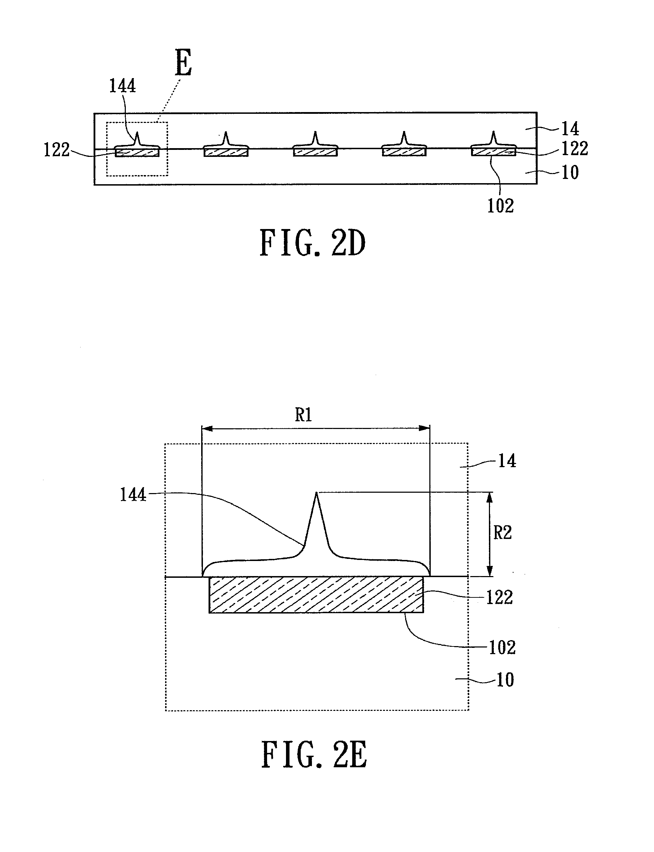

In practice, a plurality of air gaps can be formed between the reflection layer (reflection blocks 122) and the first conducting layer 14, each air gap is sandwiched between the first conducting layer 14 and one of the reflection blocks 122 within the corresponding groove 102. Referring to FIGS. 2D and 2E, FIG. 2D shows a schematic diagram of the air gap according to an embodiment of the present invention, and FIG. 2E shows an enlarged schematic diagram of area E in FIG. 2D. As shown in figures, each air gap 144 has an adjustable depth-width ratio which indicates the width R1 of the air gap 144 and the depth R2 of the air gap 144. Said depth-width ratio can be modulated according to the ratio of V semiconductor material and III semiconductor material (V/III ratio) while manufacturing the first conducting layer 14 during the epitaxy process.

For example, the width R1 of the air gap 144 and the depth R2 of the air gap 144 are extremely small (it can be considered as "no air gap") when the ratio of V semiconductor material and III semiconductor material of the first conducting layer 14 is controlled within the range of 0-2000. In contrast, the air gaps 144 can be considered as "formed" when the ratio of V semiconductor material and III semiconductor material of the first conducting layer 14 is controlled beyond 2000. In a preferred embodiment, the ratio of V semiconductor material and III semiconductor material of the first conducting layer 14 is controlled within the range of 2000-3000. In practice, the reflection efficiency can be enhanced if the reflection blocks 122 are collocated with the air gaps 144 having appropriate size. To be noted, the present invention does not limit that the LED structure 1 must have the air gaps 144, the LED structure 1 of the present invention without the air gaps 144 can also reflect the light generated by the light emitting layer 16.

[An embodiment for manufacturing LED structure]

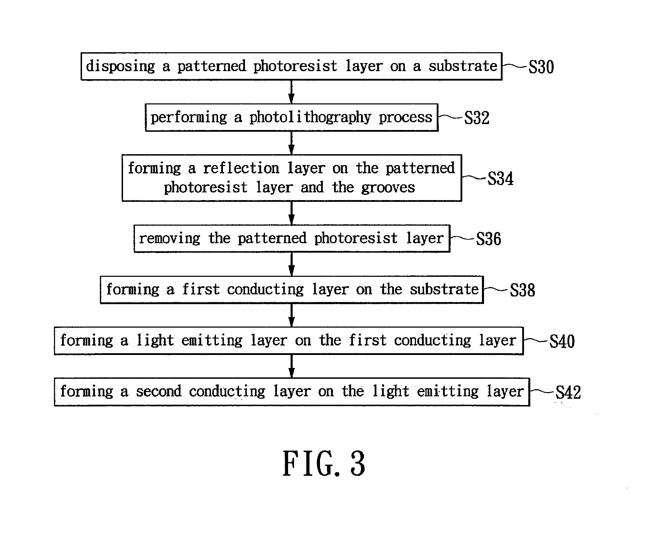

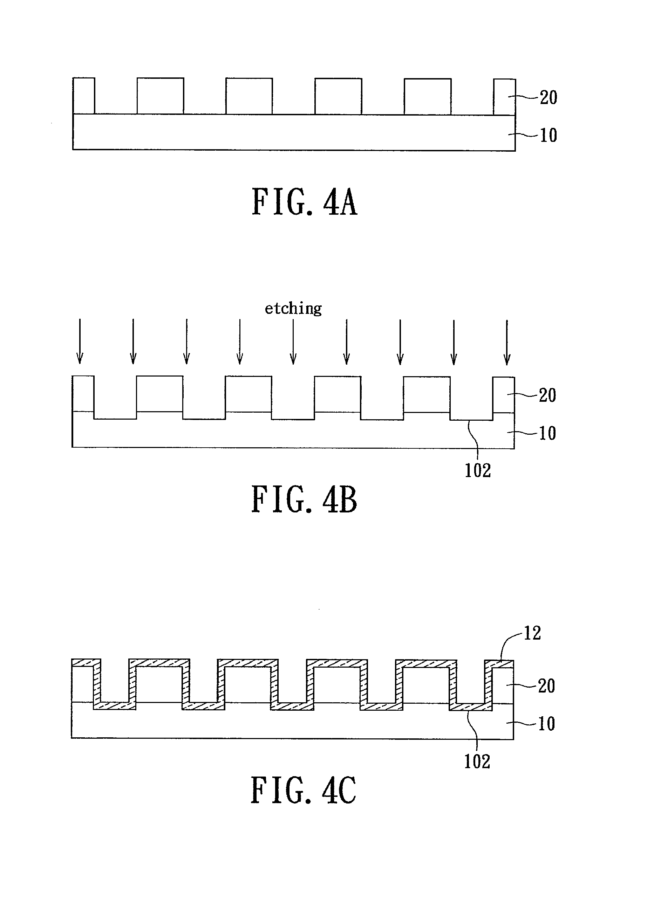

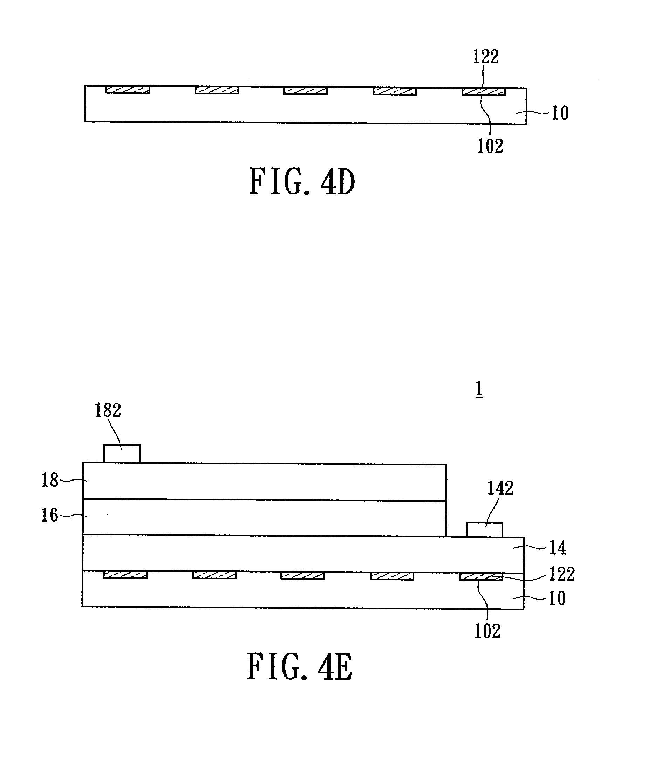

Referring to FIG. 3, FIG. 4A, FIG. 4B, FIG. 4C, FIG. 4D, and FIG. 4E, FIG. 3 shows a flow chart of manufacturing the LED structure according to an embodiment of the present invention, FIGS. 4A-4E show sectional views of the LED structure during a manufacturing process according to an embodiment of the present invention. In step S30 and FIG. 4A, a patterned photoresist layer 20 can be disposed on the substrate 10,wherein the patterned photoresist layer 20 can be regularly disposed on the surface of the substrate 10 in arrayed fashion, or the patterned photoresist layer 20 can be randomly disposed on the surface of the substrate 10. Portions of the substrate 10 covered by said patterned photoresist layer 20 shall be corresponded to the area without the grooves 102, and the other portions not covered by said patterned photoresist layer 20 shall be corresponded to the area configured to form the grooves 102.

In step S32 and FIG. 4B, a photolithography process is performed for etching the uncovered area of the surface of the substrate 10, and the grooves 102 can be formed within the uncovered area after the photolithography process. In practice, the grooves 102 are sunken portions of the substrate 10 can be, but not limited to, formed by the photolithography process. For example, the grooves 102 can be formed by other physical or chemical means, and the grooves 102 can further be preformed on the substrate 10.

In step S34 and FIG. 4C, the reflection layer 12 can be formed on the patterned photoresist layer 20 and the grooves 102, and the reflection layer 12 can be formed as one of the plurality of reflection blocks 122 inside each groove 102. In step S36 and FIG. 4D, the patterned photoresist layer 20 is removed, only the substrate 10 and the structure in the substrate 10 are left. The thickness of each reflection block 122 and the depth of each groove 102 shall be substantially the same, so that the reflection blocks 122 disposed inside the grooves 102 and the upper surface could be in substantially coplanar after removing the patterned photoresist layer 20.

In step S38 and FIG. 4E, the first conducting layer 14 can be formed on the substrate 10 and covers the grooves 102. Then, in steps S40 and S42, the light emitting layer 16 can be formed on the first conducting layer 14, and the second conducting layer 18 can be formed on the light emitting layer 16.

To sum up, the reflection layer of the present invention is disposed inside the grooves of the substrate, and that makes the upper surface of the substrate and the reflection layer (reflection blocks) be in substantially coplanar. Accordingly, the layers (e.g. conducting layers) can be easily disposed on the substrate because the upper surface of the substrate is not scraggly. Furthermore, the LED structure of the present invention can gather the light generated by the light emitting layer and direct the light to emit toward the emergence surface, that the illumination of the LED structure of the present invention can be greatly enhanced.

The descriptions illustrated *supra* set forth simply the preferred embodiments of the present invention; however, the characteristics of the present invention are by no means restricted thereto. All changes, alternations, or modifications conveniently considered by those skilled in the art are deemed to be encompassed within the scope of the present invention delineated by the following claims.

## Claims

1. A LED structure, comprising:
a substrate having a plurality of grooves;
a reflection layer, disposed inside the grooves, being formed as a plurality of reflection blocks, each reflection block being disposed inside one of the grooves;
a first conducting layer being disposed on the substrate and covering the grooves;
a light emitting layer being disposed on the first conducting layer; and
a second conducting layer being disposed on the light emitting layer;
wherein the light emitting layer generates light when a current pass through the first conducting layer, the light emitting layer, and the second conducting layer.

2. The LED structure according to claim 1, wherein a plurality of air gaps are formed between the reflection layer and the first conducting layer, each air gap is sandwiched between the first conducting layer and one of the reflection blocks within the corresponding groove.

3. The LED structure according to claim 2, wherein each air gap has a depth-width ratio, the depth-width ratio is modulated according to the ratio of V semiconductor material and III semiconductor material while manufacturing the first conducting layer during an epitaxy process.

4. The LED structure according to claim 2, wherein the ratio of V semiconductor material and III semiconductor material of the first conducting layer is controlled beyond 2000.

5. The LED structure according to claim 4, wherein the ratio of V semiconductor material and III semiconductor material of the first conducting layer is controlled within the range of 2000-3000.

6. The LED structure according to claim 1, wherein no air gaps is formed between the reflection layer and the first conducting layer, when the ratio of V semiconductor material and III semiconductor material of the first conducting layer is controlled within the range of 0-2000.

7. The LED structure according to claim 1, wherein the grooves are formed on an upper surface of the substrate, and the upper surface and the reflection layer disposed inside the grooves are in coplanar.

8. The LED structure according to claim 1, wherein the material of the substrate is selected from the group consisting of silicon, gallium nitride, aluminium nitride, sapphire, spinel, silicon carbide, gallium arsenide, aluminium oxide, lithium gallium oxide, lithium aluminium oxide, and magnesium aluminum oxide.

9. A method for manufacturing a LED structure, comprising the following steps:
disposing a patterned photoresist layer on a substrate;
performing a photolithography process for etching a plurality of portions of the substrate which are not covered by the patterned photoresist layer, and forming a plurality of grooves of the substrate, the locations of the grooves are corresponded to the portions;
forming a reflection layer on the patterned photoresist layer and the grooves, and the reflection layer being formed as one of a plurality of reflection blocks inside each groove;
removing the patterned photoresist layer;
forming a first conducting layer on the substrate, and the first conducting layer covering the grooves;
forming a light emitting layer on the first conducting layer; and
forming a second conducting layer on the light emitting layer;
wherein the light emitting layer generates light when a current pass through the first conducting layer, the light emitting layer, and the second conducting layer.

10. The method according to claim 9, wherein a plurality of air gaps are formed between the reflection layer and the first conducting layer, each air gap is sandwiched between the first conducting layer and one of the reflection blocks within the corresponding groove.

11. The method according to claim 10, wherein each air gap has a depth-width ratio, the depth-width ratio is modulated according to the ratio of V semiconductor material and III semiconductor material while manufacturing the first conducting layer during an epitaxy process.

12. The method according to claim 10, wherein the ratio of V semiconductor material and III semiconductor material of the first conducting layer is controlled beyond 2000.

13. The method according to claim 9, wherein no air gaps is formed between the reflection layer and the first conducting layer, when the ratio of V semiconductor material and III semiconductor material of the first conducting layer is controlled within the range of 0-2000.

14. The method according to claim 9, wherein the grooves are formed on an upper surface of the substrate, and the upper surface and the reflection layer disposed inside the grooves are in coplanar.

15. The method according to claim 9, wherein the material of the substrate is selected from the group consisting of silicon, gallium nitride, aluminium nitride, sapphire, spinel, silicon carbide, gallium arsenide, aluminium oxide, lithium gallium oxide, lithium aluminium oxide, and magnesium aluminum oxide.
